# EUROPEAN PATENT APPLICATION

(11) **EP 4 683 461 A1**
(43) Date of publication of application: **21.01.2026**
(21) Application number: 25763219.0
(22) Date of filing: 23.04.2025
(51) Int. Cl.: H10F 19/20

(54) **BATTERY STRING AND PHOTOVOLTAIC MODULE**

(30) Priority: 30.05.2024 CN 202410692349
(71) Applicant: Longi Photovoltaic Technology (Jiaxing) Co., Ltd., Wangdian Town, Xiuzhou District Jiaxing, Zhejiang 314011 (CN)
(72) Inventor: LIN, Hua, Jiaxing, Zhejiang 314011 (CN); ZHANG, Liang, Jiaxing, Zhejiang 314011 (CN); WANG, Weide, Jiaxing, Zhejiang 314011 (CN); FENG, Chunnuan, Jiaxing, Zhejiang 314011 (CN); LYU, Yuan, Jiaxing, Zhejiang 314011 (CN)
(74) Representative: Grünecker Patent- und Rechtsanwälte PartG mbB
(86) International application number: PCT/CN2025/090765
(87) International publication number: WO 2025/246741

(57) **Abstract**

The present application provides a solar cell string and a photovoltaic module. The solar cell string includes a solar cell and a conductive member. The conductive member has an extension end. The extension end is a portion of the conductive member that extends out of the side of the first connecting member close to the solar cell, and a length of the extension end along the first direction is greater than a length of the first projecting portion along the first direction. The first projecting portion isolates the conductive member and the solar cell, so as to prevent the finger electrode near a pad from being soldered off due to a high temperature of soldering, and reduce damage to the solar cell due to the high temperature of soldering.

## Description

### TECHNICAL FIELD

The present application relates to the technical field of photovoltaics, and in particular to a solar cell string and a photovoltaic module.

### BACKGROUND

Solar cell electrodes play an important role in collecting and transporting electrons. When assembling photovoltaic modules using a plurality of solar cells, adjacent solar cell electrodes are typically interconnected via solder ribbons. The solar cell electrodes include busbars and fingers having different polarities, and the busbars or the fingers having different polarities are alternately disposed and spaced apart from each other. When solder ribbons are soldered to the adjacent solar cell electrodes, there are two frequent issues as follows. Short-circuiting due to accidental contact between the ends of the solder ribbons and the electrodes having opposite polarities is likely to occur. In addition, the solder ribbons may contact the solar cells during soldering such that a high temperature of soldering causes fingers near the pad to be soldered off. As a result, the solder ribbons exhibit low connection reliability, and the photovoltaic modules have reduced assembly quality.

How to improve a success rate of connection of the solder ribbon and how to prevent fingers near the pad from being soldered off during soldering become technical problems that need to be solved.

### SUMMARY

A solar cell string and a photovoltaic module provided in the present application can solve at least one of the foregoing technical problems.

An embodiment of the solar cell string provided in the present application is implemented as follows:
A solar cell string includes a solar cell, an insulating member, and a conductive member. The solar cell includes a plurality of first finger electrodes, a plurality of second finger electrodes, and a first connecting member on a first surface of the solar cell. The first finger electrodes and the second finger electrodes have opposite polarities, and are sequentially and alternately disposed and spaced apart along the first direction. The first connecting member is disposed close to an edge of the solar cell and electrically connected to at least one of the first finger electrodes. The insulating member is disposed between the first connecting member and the edge of the solar cell and covers at least a portion of one of the second finger electrodes. The conductive member extends along the first direction and is connected to the first connecting member. The conductive member has an extension end. The extension end is a portion of the conductive member that extends out of the side of the first connecting member close to the edge of the solar cell, and the extension end is at least partially disposed on the insulating member. A thickness of the insulating member is h1, and a thickness of the conductive member is h2, where h1/h2 ≥ 10%. In the solar cell string of the present application, the extension end of the conductive member is isolated from the electrode structure by using the insulating member, thereby reducing a risk that the extension end is in contact with the electrodes having opposite polarities. In addition, a size relationship between the thickness of the insulating member and the thickness of the conductive member is restricted, so that in a case that the conductive member has a burr due to a manufacturing process, it is ensured that the burr cannot penetrate the insulating member, thereby further reducing the risk of short-circuiting, and fully improving safety and success rate of connection of the conductive member.

An embodiment of the present application further provides a solar cell string, including a solar cell and a conductive member. The solar cell includes a first connecting member and a plurality of first finger electrodes on a first surface of the solar cell. The first connecting member is disposed close to an edge of the solar cell and electrically connected to at least one of the first finger electrodes. A side of the first connecting member is provided with a first projecting portion connected to the first connecting member. The first projecting portion projects from the first connecting member toward the edge of the solar cell along a first direction. The conductive member extends along the first direction and connected to the first connecting member. The conductive member has an extension end. The extension end is a portion of the conductive member that extends out of the side of the first connecting member close to the edge of the solar cell, and a length of the extension end along the first direction is greater than a length of the first projecting portion along the first direction. The first projecting portion can isolate the conductive member and the solar cell in a process of soldering the first connecting member and the conductive member, thereby reducing damage to the solar cell due to a high temperature of soldering, and facilitating improving assembly quality of the photovoltaic module. Further, the first projecting portion can further be used for connecting the first finger electrode and the first connecting member, which can not only ensure an electrical connection between the first connecting member and the first finger electrode, but also reduce the requirements for preparation precision of the first connecting member. The first projecting portion can further increase an electrical contact area between the conductive member and the first connecting member, thereby improving reliability of connection between the conductive member and the first connecting member.

An embodiment of the present application further provides a photovoltaic module, including a plurality of the solar cell strings according to the foregoing embodiments. The plurality of solar cell strings are connected in parallel or in series.

### BRIEF DESCRIPTION OF THE DRAWINGS

To describe the technical solutions of the embodiments of the present application more clearly, the following briefly introduces the accompanying drawings in the embodiments. It should be understood that the following accompanying drawings show only some embodiments of the present application, and therefore should not be considered as limiting the scope. A person of ordinary skill in the art can still obtain other related drawings from these accompanying drawings without creative efforts.
FIG. 1 is a schematic partial structural view of a solar cell string according to a first embodiment of the present application.
FIG. 2 is a partial structural sectional view of the solar cell string shown in FIG. 1.
FIG. 3 is a partial structural sectional view of a solar cell string according to a second embodiment.
FIG. 4 is a schematic partial structural view of the solar cell string according to the second embodiment.
FIG. 5 is a schematic partial structural view of a solar cell string according to a third embodiment.
FIG. 6 is a schematic partial structural view of a solar cell string according to a fourth embodiment.
FIG. 7 is a schematic partial structural view of a solar cell string according to a fifth embodiment.
FIG. 8 is a schematic partial structural view of a solar cell string according to a sixth embodiment.

**Description of reference numerals:**

| | |
|---|---|
| solar cell string | 100 |
| solar cell | 10 |
| first side | 11 |
| second side | 12 |
| corner | 13 |
| first electrode | 20 |
| first busbar electrode | 21 |
| first finger electrode | 22 |
| first connecting member | 30 |
| first projecting portion | 31 |
| bonding layer | 32 |
| connection line | 33 |
| insulating member | 40 |
| conductive member | 50 |
| extension end | 51 |
| protrusion | 52 |
| second electrode | 60 |
| second busbar electrode | 61 |
| Second finger electrode | 62 |
| bent end | 63 |
| second connecting member | 70 |
| first direction | A |
| second direction | B |

The present application is further described in the following specific implementations with reference to the foregoing accompanying drawings.

### DETAILED DESCRIPTION

The technical solutions in embodiments of the present application are clearly and completely described below with reference to the accompanying drawings in the embodiments of the present application. Apparently, the described embodiments are merely some rather than all of the embodiments of the present application.

It should be noted that when a component is expressed as being "fixed to" another component, the component may be directly on the another component, or an intervening component may exist between the component and the another component. When a component is described as being "connected to" another component, the component may be directly connected to the another component, or an intervening component may exist between the component and the another component. When a component is described as being "disposed on" another component, the component may be directly disposed on the another component, or an intervening component may exist between the component and the another component. The terms "vertical", "horizontal", "left", "right", and similar expressions used in this specification are merely used for an illustrative purpose.

Unless otherwise defined, meanings of all technical and scientific terms used in this specification are the same as those usually understood by a person skilled in the art to which the present application belongs. The terms used in the specification of the present application herein are merely intended to describe objectives of the specific implementations, but not intended to limit the present application. The term "and/or" used in this specification includes any or all combinations of one or more related listed items.

Some implementations of the present application will be described in detail. The implementations and features in the implementations below may be combined with each other in the case of no conflict.

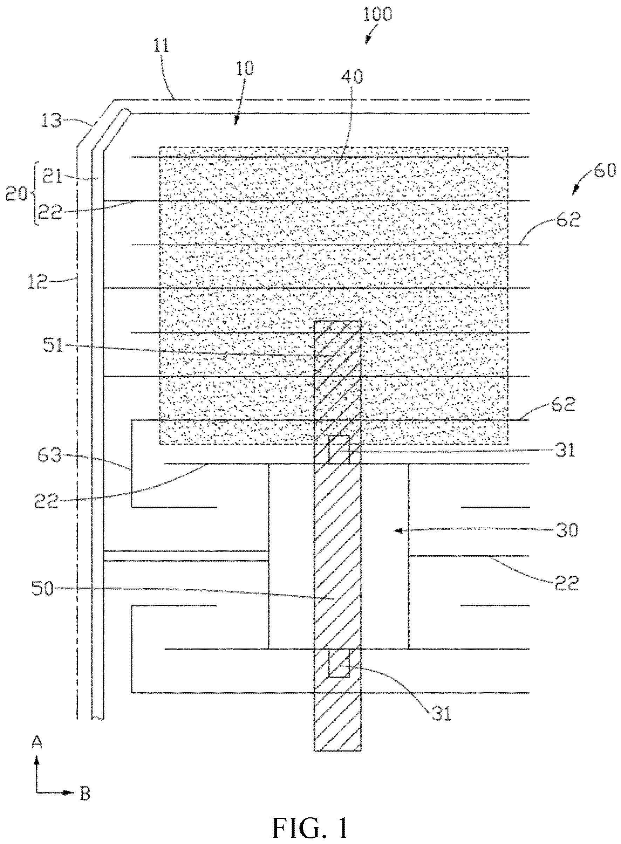

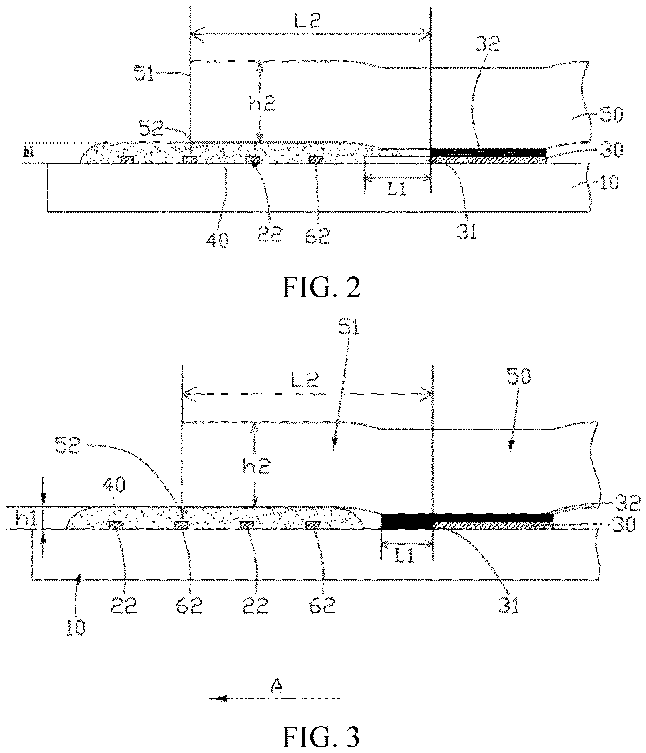

Referring to FIG. 1 and FIG. 2, this embodiment provides a solar cell string 100, including a solar cell 10, an insulating member 40, and a conductive member 50. FIG. 1 is a schematic partial structural view of the solar cell string 100, and FIG. 2 is a sectional view of the solar cell string 100 along an extension direction of the conductive member 50. The solar cell 10 includes a first electrode 20, a second electrode 60, and a first connecting member 30 on a first surface of the solar cell. The first electrode 20 and the second electrode 60 have opposite polarities. The first electrode 20 includes a plurality of first finger electrodes 22, and the second electrode 60 includes a plurality of second finger electrodes 62. The first finger electrodes 22 and the second finger electrodes 62 have opposite polarities, and the first finger electrodes 22 and the second finger electrodes 62 are sequentially and alternately disposed and spaced apart from each other along a first direction A. The first connecting member 30 is disposed close to an edge of the solar cell 10 and electrically connected to at least one of the first finger electrodes 22. The insulating member 40 is disposed between the first connecting member 30 and the edge of the solar cell 10 and covers at least a portion of one of the second finger electrodes 62. The conductive member 50 extends along the first direction A and is connected to the first connecting member 30. The conductive member 50 has an extension end 51. The extension end 51 is a portion of the conductive member 50 that extends out of the side of the first connecting member 30 close to an edge of the solar cell 10, and the extension end 51 is at least partially disposed on the insulating member 40. A thickness of the insulating member 40 is h1, and a thickness of the conductive member 50 is h2, where h1/h2 ≥ 10%.

In an embodiment of the present application, the solar cell 10 in the solar cell string 100 may be a back contact solar cell, and the first surface of the solar cell 10 is a back surface, so as to reduce blocking of a front surface of the solar cell 10 by the electrodes, thereby helping improve the energy conversion efficiency of the solar cell 10. Correspondingly, structures such as the insulating member 40 and the conductive member 50 may also be disposed on the back surface of the solar cell 10. In other embodiments, the first surface of the solar cell 10 may alternatively be a light receiving surface, as long as a design requirement is met. The present application is not limited thereto.

It is found that, the greater the thickness of the conductive member 50, the greater the length of the burr after cutting, and the greater the risk of short-circuiting between the conductive member and the solar cell. For example, when the thickness of the conductive member is 350 micrometers, the length of the burr after cutting is approximately 20-35 micrometers. During lamination, at least a portion of the burr is pressed into the insulating member 40. Therefore, it is safe to design the insulating member to have a thickness greater than or equal to 35 micrometers. When the thickness of the conductive member is 200 micrometers, the length of the burr after cutting is approximately 10-20 micrometers. During lamination, at least a portion of the burr is pressed into the insulating member 40. Therefore, it is safe to design the insulating member to have a thickness greater than or equal to 20 micrometers. In the solar cell string 100 of the present application, the extension end 51 of the conductive member 50 is isolated from the electrode structure by using the insulating member 40, thereby reducing a risk that the extension end 51 is in contact with the electrodes having opposite polarities. In addition, a size relationship between the thickness of the insulating member 40 and the thickness of the conductive member 50 is restricted, so that in a case that the conductive member 50 has a burr due to a manufacturing process, it is ensured that the burr cannot penetrate the insulating member 40, thereby further reducing the risk of short-circuiting, and fully improving safety and success rate of connection of the conductive member 50.

In an embodiment of the present application, the solar cell 10 may be considered as a zero busbar (that is, 0BB) solar cell, and the entire solar cell has no conventional busbar. In other implementations, as shown in FIG. 1 to FIG. 4, the solar cell 10 may also be a conventional busbar-containing solar cell. The first electrode 20 may further include a first busbar electrode 21. The first finger electrodes 22 are connected to the first busbar electrode 21. The second electrode 60 may further include a second busbar electrode 61. The second finger electrodes 62 are connected to the second busbar electrode 61. The first busbar electrode 21 and the second busbar electrode 61 are disposed parallel to and spaced apart from each other along a second direction B. The first direction A crosses the second direction B. The second finger electrodes 62 are spaced apart from the first connecting member 30, to avoid internal short-circuiting of the solar cell string 100 caused by electrical connection between the second finger electrodes 62 and the first finger electrodes 22.

In an implementation, there may also be a plurality of first busbar electrodes 21 and a plurality of second busbar electrodes 61. The plurality of second busbar electrodes 61 and the plurality of first busbar electrodes 21 are alternately disposed and spaced apart from each along the second direction B, and the plurality of first finger electrodes 22 and the plurality of second finger electrodes 62 are disposed spaced apart from each other between the first busbar electrodes 21 and the second busbar electrodes 61 along the first direction A.

In an embodiment of the present application, the first connecting member 30 may be a pad structure disposed on a surface of the solar cell 10, and the conductive member 50 may be a metal solder ribbon. The conductive member 50 is connected to the first connecting member 30 by soldering. The conductive member 50 in the form of a solder ribbon may cover one or more first finger electrodes 22, so as to implement an electrical connection to the first finger electrode 22. The insulating member 40 may be, but is not limited to, an insulating adhesive. The extension end 51 is a strip-like region between an end of the conductive member 50 and an outer side (a side close to the edge of the solar cell) of the first connecting member 30. The extension end 51 is disposed on an upper surface of the insulating member 40, and the insulating member 40 isolates the extension end 51 of the conductive member 50 from the electrodes, thereby avoiding short-circuiting. Along the first direction A, a length of the insulating member 40 is greater than a length of the extension end 51. Along the second direction B, a width of the insulating member 40 is greater than a width of the first connecting member 30. In this way, even if the extension end 51 wobbles or deviates during mounting, the extension end is within the surface region of the insulating member 40 and cannot easily contact with the electrodes on the surface of the solar cell 10, thereby improving safety of the solar cell string 100. In an embodiment, as shown in FIG. 2 and FIG. 3, an upper surface of the first connecting member 30 is further provided with a bonding layer 32. The bonding layer 32 is electrically conductive, and can connect the first connecting member 30 and the conductive member 50 during soldering. In an embodiment, a material of the bonding layer 32 may be a solder, a conductive adhesive, a low-temperature solder, or the like.

In some implementations, the thickness h2 of the conductive member 50 is 150 µm-350 µm. The thickness h1 of the insulating member 40 is 30 µm-100 µm. A larger thickness of the insulating member 40 indicates higher safety performance. A larger thickness of the conductive member 50 indicates a smaller resistance. However, an excessively large thickness of the insulating member 40 and the conductive member 50 may affect the mounting effect and increase product costs. In this embodiment of the present application, the size ranges of the conductive member 50 and the insulating member 40 are further restricted, so that on the premise of meeting the safety of connection, the resistance of the conductive member 50 is reduced, and economic costs are controlled to be in an acceptable range.

In some implementations, as shown in FIG. 2, a side of the extension end 51 on the insulating member 40 has protrusions 52 (spikes). The protrusions 52 are partially inserted into the insulating member 40, and a depth by which the protrusions 52 are inserted into the insulating member 40 is less than the thickness of the insulating member 40, so as to prevent the protrusions 52 from contacting the electrodes having opposite polarities below the insulating member 40 to cause a short circuit. The protrusions 52 are integrally formed with a main portion of the conductive member 50. The protrusions 52 may be formed on an outer edge of the extension end 51 when the conductive member 50 is cut or trimmed. When the conductive member 50 and the first connecting member 30 are soldered together, the extension end 51 may be positioned on the surface of the insulating member 40 by using the protrusions 52, so as to restrict a degree of freedom of the extension end 51, and prevent the extension end 51 from wobbling and being accidentally in contact with the electrodes having opposite polarities.

The insulating member 40 is mainly used for covering the second finger electrodes 62 intersecting with the extension end 51, to isolate the extension end 51 from the second finger electrodes 62, thereby reducing short-circuiting.

In some embodiments, along the first direction A, a side of the first connecting member 30 is provided with a first projecting portion 31 connected to the first connecting member 30. The first projecting portion 31 is electrically connected to at least one of the first finger electrodes 22, and the first projecting portion 31 is spaced apart from the second finger electrodes 62. The conductive member 50 covers the first projecting portion 31. When the conductive member 50 is connected to the first connecting member 30 by soldering, the first projecting portion 31 can isolate the solar cell 10 at the edge of the first connecting member 30 from contacting with the conductive member 50, so that the solar cell 10 is protected from soldering heat, and the fingers near the pad are prevented from being soldered off, thereby reducing damage to the solar cell 10 during soldering. The first projecting portion 31 may further increase an electrical contact area between the first connecting member 30 and the conductive member 50, thereby improving reliability of connection between the conductive member 50 and the first connecting member 30.

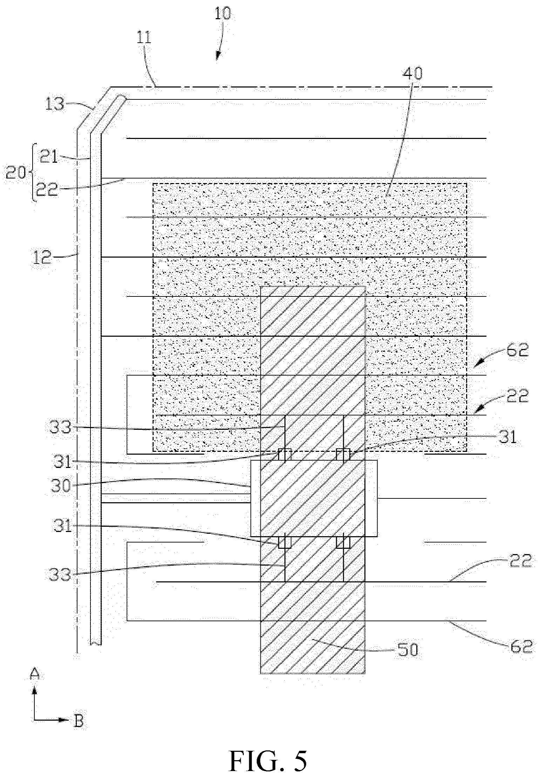

In FIG. 1 to FIG. 4, the first projecting portion 31 is directly connected to the first connecting member 30, and the first projecting portion 31 is directly electrically connected to the first finger electrodes 22 having the same polarity closest to the first connecting member 30. However, in other implementations, as shown in FIG. 5, a difference from FIG. 1 is that the first projecting portion 31 is electrically connected to at least one of the first finger electrodes 22 through a connection line 33. There may be one, two, or more first projecting portions 31. For example, along the second direction B, at least two first projecting portions 31 are spaced apart, and a distance between the adjacent first projecting portions 31 is less than a size of the conductive member 50 along the second direction B, so that the conductive member 50 can cover a plurality of the first projecting portions 31. Each first projecting portion 31 is correspondingly connected to one connection line 33. Replacing a large first projecting portion 31 with a small first projecting portion 31 can reduce an area occupied by a single first projecting portion 31 on the solar cell 10, which can adapt to different mounting requirements.

In an embodiment of the present application, along the first direction A, the conductive member 50 extends out from two opposite sides of the first connecting member 30, and two first projecting portions 31 are also respectively correspondingly disposed on the two opposite sides of the first connecting member 30, to contact and support the portions of the conductive member 50 that extend out from the sides of the first connecting member 30. Further, along the first direction A, one first finger electrode 22 is respectively connected to the two opposite sides of the first connecting member 30. When a position deviation of the first connecting member 30 is caused by a manufacturing process, the first projecting portion 31 can ensure an electrical connection between the first finger electrodes 22 and the first connecting member 30, and prevent the first finger electrodes 22 closest to the side of the first connecting member 30 from being soldered off.

In an embodiment of the present application, along the first direction A, a length L1 of the first projecting portion 31 is less than a distance between the first finger electrode 22 and the adjacent second finger electrode 62, so that when the first projecting portion 31 is connected to the first finger electrode 22, the first projecting portion remains spaced apart from the second finger electrode 62, so as to prevent the first projecting portion 31 from contacting the second finger electrode 62, and reduce a risk of internal short-circuiting of the solar cell string 100.

In some embodiments, as shown in FIG. 1, FIG. 2, FIG. 5, and FIG. 6, along the first direction A, a length L1 of the first projecting portion 31 may be greater than a distance between the insulating member 40 and a side of the first connecting member 30, and the insulating member 40 may cover a portion of the first projecting portion 31. In this way, the insulating member 40 can fully cover the second finger electrode 62 adjacent to the first connecting member 30, thereby reducing a problem that the second finger electrode 62 is exposed below the extension end 51 due to a manufacturing process error.

In other embodiments, as shown in FIG. 3 to FIG. 4, the length L1 of the first projecting portion 31 may alternatively be less than a distance between the insulating member 40 and a side of the first connecting member 30, so that the first projecting portion 31 and the insulating member 40 are spaced apart, thereby reducing a risk that the insulating member 40 is damaged by a high temperature during soldering.

The extension end 51 of the conductive member 50 needs to exist during soldering. The extension end 51 can be used for enabling an endmost pressing pin to press the end (i.e., the extension end 51) of the solder ribbon during string soldering, so as to facilitate soldering, ensure a certain soldering tolerance, and avoid poor soldering caused by up-and-down expansion and retraction of the conductive member 50. In some embodiments, a distance L2 by which the extension end 51 extends out of the side of the first connecting member 30 (excluding the first projecting portion) is 2 mm-5 mm. The size of the extension end 51 extending out of the first connecting member 30 is restricted, so as to avoid an excessively large degree of freedom caused by an excessively large length of the extension end 51, thereby reducing short-circuiting caused by deviation of the extension end 51 from the insulating member 40. Further, as shown in FIG. 1 and FIG. 2, along the first direction A, the extension end 51 intersects with at least two second finger electrodes 62. In this way, the size of the extension end 51 can be controlled within a proper range, so as to reduce a problem that a pressing tool cannot press the extension end 51 firmly during soldering due to the excessively small length of the extension end 51, thereby facilitating improving the soldering yield.

As shown in FIG. 2 and FIG. 3, in some embodiments, an upper surface of the extension end 51 that faces away from the solar cell 10 is higher than an upper surface of the conductive member 30 that faces away from the solar cell 10 at the first connecting member 50, so as to identify an electric connection region on the conductive member 50, thereby facilitating subsequent quality inspection.

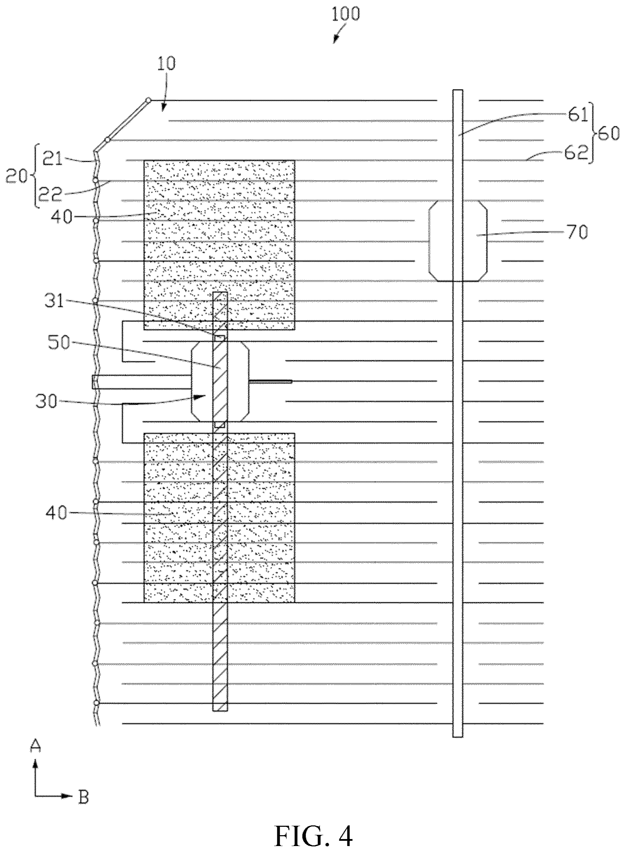

Referring to FIG. 4, in other embodiments, the solar cell string 100 may further include a second connecting member 70. The second connecting member 70 is connected to the second busbar electrode 61. The first finger electrodes 22 and the second connecting member 70 are spaced apart. The second connecting member 70 may also be a pad structure used for soldering a metal solder ribbon or a conductive line corresponding to the second electrode 60.

In an embodiment of the present application, the solar cell 10 has a roughly rectangular structure. The rectangular solar cell 10 has a first side 11 and a second side 12 that are adjacent and perpendicular to each other, as shown in FIG. 1 and FIG. 5. The dashed box in the figure is an example of the structure of an edge of the solar cell 10, but the present application is not limited thereto. The solar cell 10 further includes a corner 13. The corner 13 is formed between the first side 11 and the second side 12, and may be a chamfer structure between the first side 11 and the second side 12. The first connecting member 30 is disposed at a position close to the corner 13, so that the position of the first connecting member 30 corresponds to that of the extension end 51 of the conductive member 50.

In some embodiments, the solar cell string 100 may further include a plurality of connecting members. The plurality of connecting members are spaced apart from each other on the solar cell 10 and correspondingly connect the first electrode 20 and the second electrode 60. The first connecting member 30 is the one closest to the corner 13 among the plurality of connecting members, that is, a distance between the first connecting member 30 and the corner 13 is less than a distance between the other connecting members and the corner 13. A plurality of first connecting members 30 and a plurality of second connecting members 70 can increase soldering points of the conductive member 50, thereby improving reliability of connection. In this embodiment of the present application, the plurality of second connecting members 70 close to the edge of the solar cell 10 have a risk of short-circuiting caused by burr penetration, which is more prominent for the second connecting member 70 at the corner 13 of the solar cell 10.

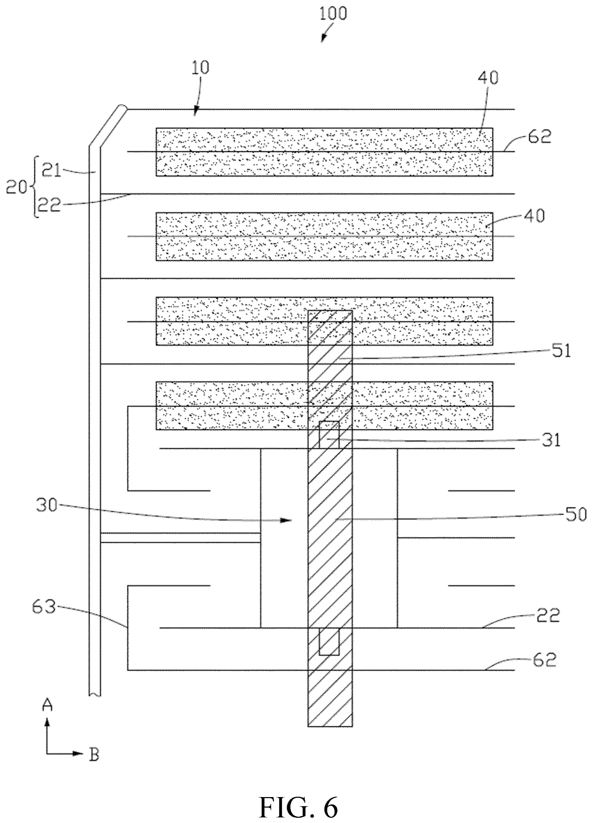

It can be understood that, a plurality of insulating members 40 (as shown in FIG. 6) may be disposed between the main portion of the conductive member 50 and the solar cell 10, to prevent the main portion of the conductive member 50 from contacting the electrodes having opposite polarities, thereby further reducing the risk of short-circuiting. The main portion of the conductive member 50 is a portion of the conductive member 50 other than the extension end 51 and the soldering region.

In some implementations, as shown in FIG. 1 to FIG. 5, the insulating member 40 covers a portion of the first finger electrode 22 and a portion of the second finger electrode 62. In this way, the insulating member 40 has a one-piece structure with a relatively large size, and can simultaneously cover some regions of the plurality of first finger electrodes 22 and the plurality of second finger electrodes 62, which is beneficial to reducing disposing steps and a disposing difficulty of the insulating member 40, and improving manufacturing efficiency.

In other embodiments, as shown in FIG. 6, there may be a plurality of insulating members 40. The plurality of insulating members 40 are spaced apart along the first direction A, and each of the insulating members 40 covers a portion of the second finger electrode 62. In this way, the insulating members 40 can cover only the second finger electrodes 62, thereby reducing a use amount of the insulating members 40.

In some embodiments, as shown in FIG. 1 to FIG. 8, the first connecting member 30 is disposed in a region in which the finger electrodes are distributed. To prevent the second finger electrodes 62 from contacting the first connecting member 30, along the second direction B, the second finger electrodes 62 is spaced apart from the first connecting member 30 by a certain distance, causing blank regions around the first connecting member 30. Along the first direction A, the second finger electrode 62 adjacent to the first connecting member 30 has a bent end 63. The bent end 63 is bent toward the first connecting member 30 and wraps around an end portion of the adjacent first finger electrode 22. The bent end 63 is approximately of a hook-back structure, and the bent end 63 is spaced apart from the first finger electrode 22, so as to avoid internal short-circuiting. In this way, the finger electrodes can fully collect current on the solar cell 10 around the first connecting member 30, thereby reducing blank regions on the solar cell 10.

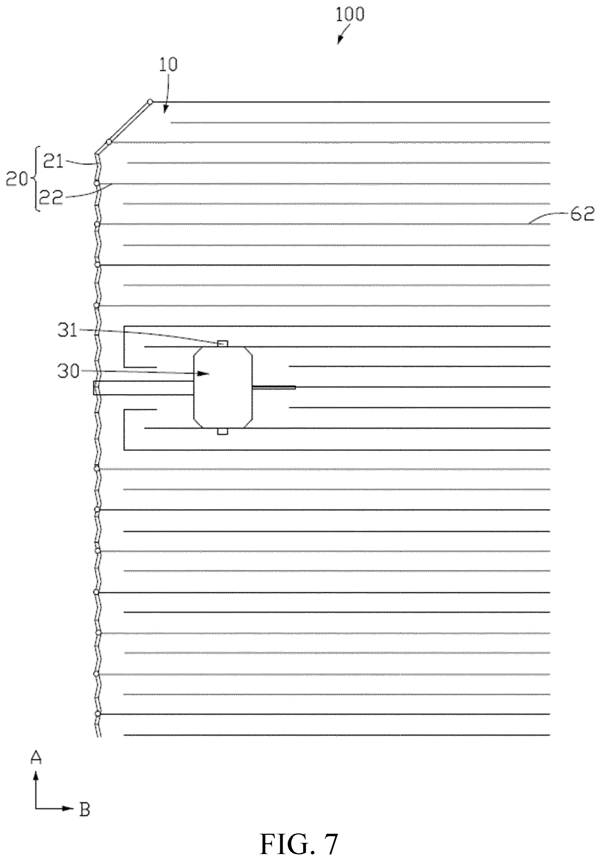

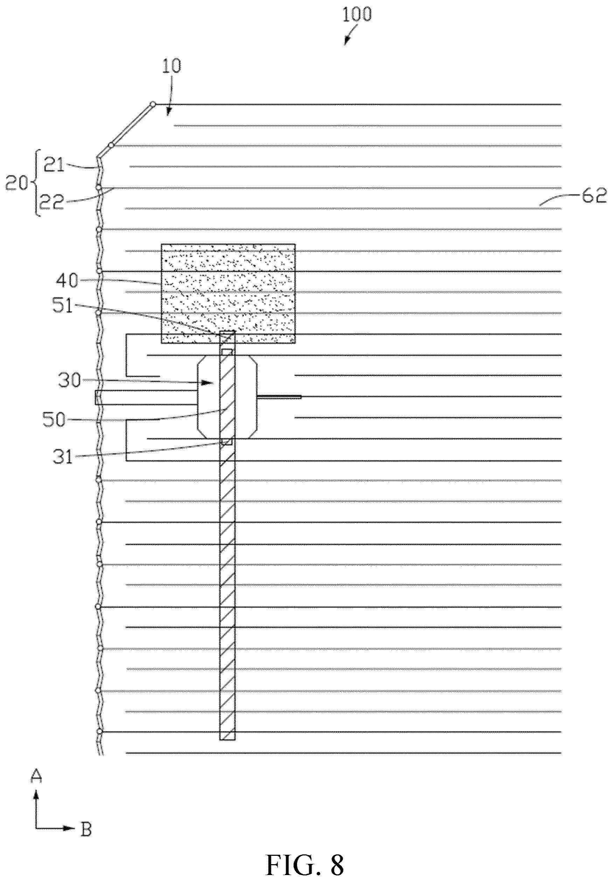

Referring to FIG. 7 and FIG. 8 again, an embodiment of the present application further provides a solar cell string 100, including a solar cell 10 and a conductive member 50. The solar cell 10 includes a plurality of first finger electrodes 22 and a first connecting member 30 on a first surface of the solar cell. The first connecting member 30 is disposed close to an edge of the solar cell 10, and the first connecting member 30 is electrically connected to at least one of the first finger electrodes 22. A side of the first connecting member 30 is provided with a first projecting portion 31 connected to the first connecting member 30, and the first projecting portion 31 projects from the first connecting member 30 toward the edge of the solar cell 10 along the first direction A. The conductive member 50 extends along the first direction A and is connected to the first connecting member 30. The conductive member 50 has an extension end 51. The extension end 51 is a portion of the conductive member 50 that extends out of the side of the first connecting member 30 close to the edge of the solar cell 10, and a length of the extension end 51 along the first direction A is greater than a length of the first projecting portion 31 along the first direction A.

The first projecting portion 31 can isolate the conductive member 50 and the solar cell 10 in a process of soldering the first connecting member 30 and the conductive member 50, so as to prevent the finger electrode near a pad from being soldered off due to a high temperature of soldering, reduce damage to the solar cell 10 due to a high temperature of soldering, and facilitate improving assembly quality of the photovoltaic module. The first projecting portion 31 can further be used for connecting the first finger electrode 22 and the first connecting member 30, which can not only ensure an electrical connection between the first connecting member 30 and the first finger electrode 22, but also reduce the requirements for preparation precision of the first connecting member 30.

In some embodiments, the solar cell 10 may be considered as a zero busbar (that is, 0BB) solar cell. The first busbar electrode 21 does not serve as a direct electrical connection portion of the first connecting member 30, and the entire solar cell has no conventional busbar. In other embodiments, the solar cell 10 may alternatively be a busbar-containing solar cell. The structure is the same as that of the foregoing embodiments, and details are not described herein again.

As shown in FIG. 8, in some embodiments, the conductive member 50 extends out of the side of the first connecting member 30 and covers the first projecting portion 31. The first projecting portion 31 can further increase an electrical contact area between the conductive member 50 and the first connecting member 30, thereby improving reliability of connection between the conductive member 50 and the first connecting member 30.

In an embodiment, the conductive member 50 has a flat strip-like structure. Along the second direction B, a width of the conductive member 50 is 0.2 mm-0.6 mm, and a width of the first projecting portion 31 is less than or equal to the width of the conductive member 50, so that the conductive member 50 and the first connecting member 30 can fully cover the first projecting portion 31 after being soldered. The first projecting portion 31 is not exposed from the conductive member 50, so that a use amount of the material of the first projecting portion 31 can be reduced while the conductive member 50 and the solar cell 10 are effectively isolated, thereby reducing manufacturing costs. The size of the conductive member 50 and the size of the first projecting portion 31 are restricted, so that the coverage of the area of the solar cell 10 can be reduced while ensuring the soldering effect and reliability of an electrical connection.

In some embodiments, as shown in FIG. 8, the solar cell string 100 further includes an insulating member 40 disposed on a side of the first connecting member 30. The conductive member 50 has an extension end 51. The extension end 51 extends out of the side of the first connecting member 30, and the extension end 51 is at least partially disposed on the insulating member 40. A thickness of the insulating member 40 is h1, and a thickness of the conductive member 50 is h2, where h1/h2 ≥ 10%. Further, a length of the first projecting portion 31 is less than a length of the extension end 51, so as to reduce a risk that the first projecting portion 31 contacts the electrodes having opposite polarities. In the embodiments shown in FIG. 7 and FIG. 8, other structures of the first connecting member 30, the first projecting portion 31, the insulating member 40, the extension end 51, the finger electrodes, and the like are roughly the same as those in the foregoing embodiments, and details are not described herein again.

An embodiment of the present application further provides a photovoltaic module, including a plurality of the solar cell strings 100 according to the foregoing embodiments or combinations of the embodiments. The plurality of solar cell strings 100 are connected in series or in parallel. Specifically, the conductive members 50 in the solar cell strings 100 can be correspondingly connected, to aggregate current in the solar cell strings 100.

In the solar cell string 100 and the photovoltaic module of the present application, the extension end 51 of the conductive member 50 is isolated from the electrode structure by using the insulating member 40, thereby reducing a risk that the extension end 51 is in contact with the electrodes having opposite polarities. In addition, a size relationship between the thickness of the insulating member 40 and the thickness of the conductive member 50 is restricted, so that in a case that the conductive member 50 has a burr due to a manufacturing process, it is ensured that the burr cannot penetrate the insulating member 40, thereby further reducing the risk of short-circuiting, and fully improving safety and success rate of connection of the conductive member 50. The first projecting portion 31 is further disposed at the side of the first connecting member 30. The first projecting portion 31 isolates the conductive member 50 and the solar cell 10 in a process of soldering the first connecting member 30 and the conductive member 50, thereby reducing damage to the solar cell 10 due to a high temperature of soldering, and facilitating improving assembly quality of the photovoltaic module.

The foregoing implementations are merely intended for describing the technical solutions of the present application, but not for limiting the present application. Although the present application is described in detail with reference to the foregoing preferred embodiments, a person of ordinary skill in the art should understand that modifications or equivalent replacements can still be made to the technical solutions of the foregoing embodiments without departing from the spirit and scope of the technical solutions of the present application.

## Claims

1. A solar cell string, comprising:
a solar cell, comprising a first connecting member and a plurality of first finger electrodes on a first surface of the solar cell, the first connecting member being disposed close to an edge of the solar cell and electrically connected to at least one of the first finger electrodes, a side of the first connecting member being provided with a first projecting portion connected to the first connecting member, and the first projecting portion projecting from the first connecting member toward the edge of the solar cell along a first direction; and
a conductive member, extending along the first direction and connected to the first connecting member, the conductive member having an extension end, the extension end being a portion of the conductive member that extends out of the side of the first connecting member close to the solar cell, and a length of the extension end along the first direction being greater than a length of the first projecting portion along the first direction.

2. The solar cell string according to claim 1, wherein
a width of the conductive member is 0.2 mm-0.6 mm, and a width of the first projecting portion is less than or equal to the width of the conductive member.

3. The solar cell string according to claim 1, wherein
the solar cell string further comprises an insulating member, disposed between the first connecting member and the edge of the solar cell; the solar cell further comprises a plurality of second finger electrodes on the first surface of the solar cell, the first finger electrodes and the second finger electrodes having opposite polarities, and being sequentially and alternately disposed and spaced apart along the first direction; the insulating member covering at least a portion of one of the second finger electrodes;
the extension end is at least partially disposed on the insulating member; and a thickness of the insulating member is h1, and a thickness of the conductive member is h2, wherein h1/h2 ≥ 10%.

4. The solar cell string according to claim 3, wherein
an upper surface of the extension end that faces away from the solar cell is higher than an upper surface of the conductive member that faces away from the solar cell at the first connecting member.

5. The solar cell string according to claim 3, wherein
the thickness of the conductive member is 150 µm-350 µm; and/or
the thickness of the insulating member is 30 µm-100 µm.

6. The solar cell string according to claim 1, wherein
the first projecting portion is electrically connected to at least one of the first finger electrodes through a connection line.

7. The solar cell string according to claim 1, wherein
along a second direction, at least two first projecting portions are spaced apart, and a distance between the adjacent first projecting portions is less than a size of the conductive member along the second direction, the second direction crossing the first direction.

8. The solar cell string according to claim 1, wherein
the solar cell comprises a corner, and a distance between the first connecting member and the corner is less than a distance between other connecting members and the corner.

9. The solar cell string according to claim 3, wherein
along the first direction, the second finger electrode adjacent to the first connecting member has a bent end, and the bent end wraps around an end portion of the first finger electrode and is spaced apart from the first finger electrode.

10. A photovoltaic module, comprising a plurality of the solar cell strings according to any one of claims 1 to 9, the plurality of solar cell strings being connected in parallel or in series.
